# EUROPEAN PATENT SPECIFICATION

(11) **EP 2 237 412 B1**
(45) Date of publication and mention of the grant of the patent: **20.07.2011**
(21) Application number: 09004811.7
(22) Date of filing: 01.04.2009
(51) Int. Cl.: H03B 21/00, H03L 7/02

(54) **Digitally controled frequency generator**
Digital gesteuerter Frequenzgenerator
Générateur de fréquence commandé numériquement

(43) Date of publication of application: 06.10.2010
(73) Proprietor: Taitien Electronics Co., Ltd., Taipei (TW)
(72) Inventor: Tignor, Todd S., Earlysville, VA 22936 (US)
(74) Representative: Patentanwälte Bressel und Partner

(56) References cited:
- EP-A1- 0 278 140
- US-A1- 2005 156 634

## Description

The invention relates to a frequency generator, more particularly to a digitally controlled frequency generator.

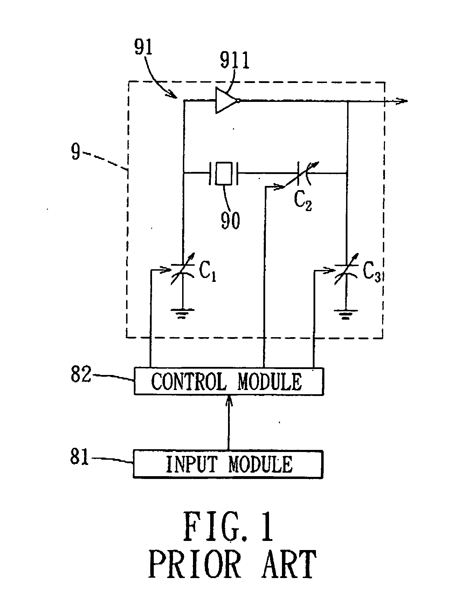

Referring to Figure 1, a conventional frequency generator is shown to include a crystal oscillator 9 for generating a clock signal, an input module 81, and a control module 82 coupled to the crystal oscillator 9 and the input module 81. The crystal oscillator 9 includes a resonance chip 90 and a tuning circuit 91. The resonance chip 90 is fabricated through cutting, waxing, halfing, rounding, dewaxing and frequency lapping procedures. The tuning circuit 91 includes an inverter 911 and a plurality of variable bad capacitors (C₁, C₂, C₃). The input module 81 is operable so as to output a control signal to the control module 82. The control module 82, such as a micro-controller, controls the crystal oscillator 9 in response to the control signal from the input module 81 to adjust capacitances of the bad capacitors (C₁, C₂, C₃) so that the clock signal generated by the crystal oscillator 9 has a specified resonance frequency.

However, the frequency of the clock signal provided by the conventional frequency generator is fixed and cannot be adjusted by the user to obtain a desired frequency.

The US 2005/156634 A1 discloses a digitally controlled frequency generator with the features of the first part of claim 1.

The EP 0 278 140 A1 discloses a clock signal generator of the type comprising a phase locked loop arrangement which includes adjustable dividing means for adjusting the clock signal rate at the output of the loop, and means for generating a reference signal for the loop, whereby the signal generator includes a further adjustable dividing means coupling the reference signal generating means to the loop. In particular the reference signal generating means comprises a voltage controlled crystal oscillator.

Therefore, an object of the present invention is to provide a digitally controlled frequency generator that can generate a clock signal having a desired frequency.

According to the present invention, a digitally controlled frequency generator comprises:
an oscillator module for generating a first clock signal having an oscillating frequency;
a programmable control module operable so as to generate a control signal corresponding to a desired frequency;
a frequency sensor coupled to said oscillator module and said programmable control module, said frequency sensor sensing the first clock signal generated by said oscillator module to output a detecting signal to said programmable control module;
wherein said programmable control module determines a difference between the oscillating frequency of the first clock signal and the predetermined oscillating frequency based on the detecting signal from said frequency sensor, said programmable control module outputting an adjusting signal to said oscillator module with reference to the detecting signal from said frequency sensor such that said oscillator module adjusts the oscillating frequency of the first clock signal generated thereby to the predetermined oscillating frequency in response to the adjusting signal from said programmable control module; and
a direct digital frequency synthesizer coupled to the oscillator module and the programmable control module receiving the first clock signal and the control signal therefrom, and generating a second clock signal having the desired frequency based on the first clock signal from the oscillator module and the control signal from the programmable control module.

Other features and advantages of the present invention will become apparent in the following detailed description of the preferred embodiment with reference to the accompanying drawings, of which:
Figure 1 is a schematic electrical circuit block diagram of a conventional frequency generator;
Figure 2 is a schematic electrical circuit block diagram illustrating the preferred embodiment of a digitally controlled frequency generator according to the present invention; and
Figure 3 is a schematic circuit block diagram illustrating a direct digital frequency synthesizer of the preferred embodiment.

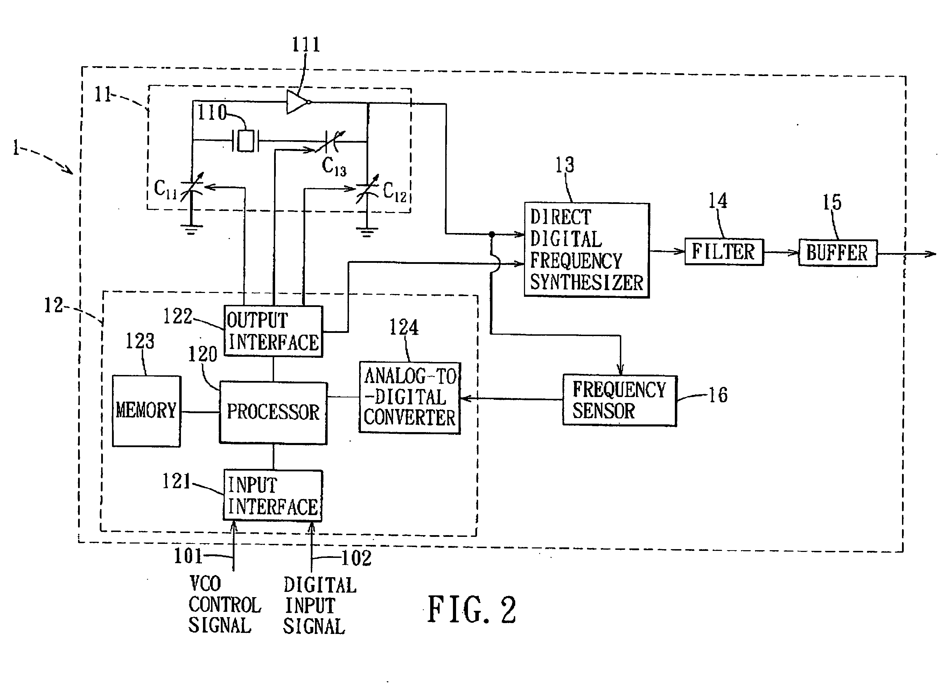

Referring to Figure 2, the preferred embodiment of a digitally controlled frequency generator 1 according to the present invention is shown to include an oscillator module 11, a programmable control module 12, a direct digital frequency synthesizer 13, a frequency sensor 16, a filter 14, and a buffer 15.

The oscillator module 11 generates a first clock signal having an oscillating frequency. In this embodiment, the oscillator module 11 includes a crystal resonator 110, and a tuning circuit consisting of an inverter 111 and a plurality of variable load capacitors (C₁₁, C₁₂, C₁₃). Preferably, the oscillating frequency of the first clock signal can meet a predetermined oscillating frequency (f_{osc}). However, due to aging, temperature and gravity acceleration factors, the oscillating frequency of the first clock signal generated by the oscillator module 11 is permitted to have a variance with the predetermined oscillating frequency (f_{osc}) within a range of the predetermined oscillating frequency (f_{osc}) x 10 PPM. In other embodiments, the oscillator module 11 can include an oven-controlled crystal oscillator.

The programmable control module 12, such as a PIC24 control module available from MicroChip Technology Corporation, is operable so as to generate a control signal corresponding to a desired frequency (fₒᵤₜ). In this embodiment, the programmable control module 12 includes an input interface 121, an output interface 122, a memory 123, an analog-to-digital converter 124, and a processor 120 coupled to the input interface 121, the output interface 122, the memory 123 and the analog-to-digital converter 124. The input interface 121 is operable so as to receive a digital input signal corresponding to the desired frequency (fₒᵤₜ). The processor 120 receives the digital input signal from the input interface 121, generates the control signal based on the digital input signal and control parameters stored in the memory 123, and outputs the control signal through the output interface 122.

The frequency sensor 16 is coupled to the oscillator module 11 and the analog-to-digital converter 124 of the programmable control module 12. The frequency sensor 16 senses the first clock signal generated by the oscillator module 11 to output a detecting signal to the analog-to-digital converter 124 of the programmable control module 12.

The analog-to-digital converter 124 of the programmable control module 124 receives the detecting signal from the frequency sensor 16, and converts the detecting signal into a digital signal.

The processor 120 receives the digital signal from the analog-to-digital converter 124, and determines a difference between the oscillating frequency of the first clock signal and the predetermined oscillating frequency (f_{osc}) based on the digital signal from the analog-to-digital converter 124 and the control parameters stored in the memory 123. It is noted that the difference between the oscillating frequency of the first clock signal and the predetermined oscillating frequency (f_{osc}) may be a result of at least one of aging of the oscillator module 11, ambient temperature, and a gravity acceleration of a position where the digitally controlled frequency generator 1 is disposed. The processor 120 outputs an adjusting signal to the oscillator module 11 through the output interface 122 with reference with the detecting signal from the frequency sensor 16, such that the oscillator module 11 adjusts the oscillating frequency of the first clock signal generated thereby to the predetermined oscillating frequency (f_{osc}) through tuning of capacitances of the load capacitors (C₁₁, C₁₂, C₁₃) in response to the adjusting signal from the processor 120. Furthermore, preferably, a voltage-controlled oscillation (VCO) control signal is inputted to processor 120 via the input interface 121. Therefore, the processor 120 controls the oscillator module 11 in response to the VCO control signal to stabilize the first clock signal generated by the oscillator module 11.

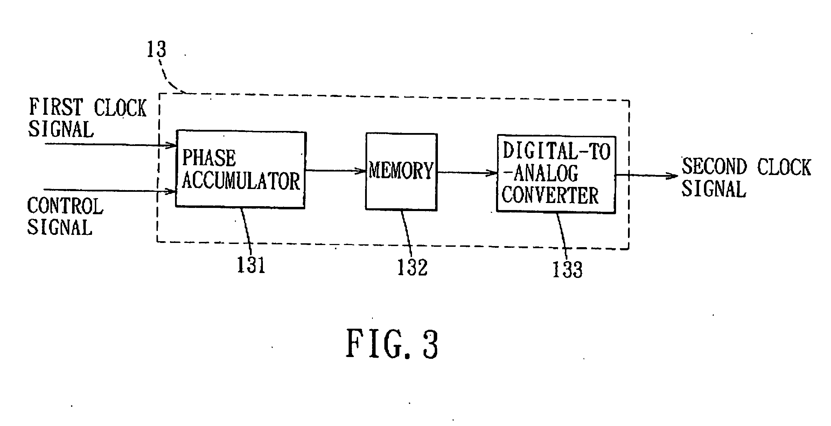

The direct digital frequency synthesizer 13 is coupled to the oscillator module 11 and the programmable control module 12 for receiving the first clock signal and the control signal therefrom, and for generating a second clock signal having the desired frequency (fₒᵤₜ) based on the first clock signal from the oscillator module 11 and the control signal from the programmable control module 12. In this embodiment, referring further to Figure 3, the direct digital frequency synthesizer 13 includes a phase accumulator 131 coupled to the oscillator module 11 and the output interface 122 of the programmable control module 12, a memory 132 coupled to the phase accumulator 131 for storing a lookup table of phases and amplitudes, and a digital-to-analog converter 133 coupled to the memory 132.

The phase accumulator 131 receives the first clock signal from the oscillator module 11 and the control signal from the output interface 122 of the programmable control module 12, generates a phase signal based on the first clock signal and the control signal, and outputs the phase signal to the memory 132. In this embodiment, the control signal is in the form of a frequency control word.

The phase signal is used to find corresponding amplitudes from the lookup table stored in the memory 132 to synthesize a digital signal having phases and amplitudes. The digital-to-analog converter 133 converts the digital signal into an analog signal that serves as the second clock signal. In this embodiment, the desired frequency (fₒᵤₜ) of the second clock signal is more than double the predetermined oscillating frequency (f_{osc}).

The second clock signal generated by the direct digital frequency synthesizer 13 is filtered by the filter 14 coupled to the direct digital frequency synthesizer 13 to remove undesired components, and is then outputted through the buffer 15 coupled to the filter 14.

In sum, due to the presence of the programmable control module 12 and the direct digital frequency synthesizer 13, the digitally controlled frequency generator 1 of this invention can generate the second clock signal based on the first clock signal generated by the oscillator module 11, where the second clock signal has the desired frequency (fₒᵤₜ). Furthermore, due to the presence of the frequency sensor 16 and the VCO control signal, the first clock signal generated by the oscillator module 11 can be maintained to have the predetermined oscillating frequency (f_{osc}).

## Claims

1. A digitally controlled frequency generator (1) comprising:
anoscillatormodule (11) for generating a first clock signal having an oscillating frequency;
a programmable control module (12) operable so as to generate a control signal corresponding to a desired frequency (fₒᵤₜ) that is more than double a predetermined oscillating frequency (f_{osc});
a frequency sensor (16) coupled to said oscillator module (11) and said programmable control module (12), said frequency sensor (16) sensing the first clock signal generated by said oscillator module (11) to output a detecting signal to said programmable control module (12) ;
wherein said programmable control module (12) determines a difference between the oscillating frequency of the first clock signal and the predetermined oscillating frequency (f_{osc}) based on the detecting signal from said frequency sensor (16), said programmable control module (12) outputting an adjusting signal to said oscillator module (11) with reference to the detecting signal from said frequency sensor (16) such that said oscillator module (11) adjusts the oscillating frequency of the first clock signal generated thereby to the predetermined oscillating frequency (f_{osc}) in response to the adjusting signal from said programmable control module (12), **characterized by**
a direct digital frequency synthesizer (13) coupled to said oscillator module (11) and said programmable control module (12) receiving the first clock signal and the control signal therefrom, and generating a second clock signal having the desired frequency (fₒᵤₜ) based on the first clock signal from said oscillator module (11) and the control signal from said programmable control module (12).

2. The digitally controlled frequency generator (1) as claimed in Claim 1, further **characterized in that** said programmable control module (12) includes:
an input interface (121) operable so as to receive an input signal corresponding to the desired frequency (fₒᵤₜ);
an analog-to-digital converter (124) coupled to said frequencysensor (16) for receiving the detecting signal therefrom and for converting the detecting signal into a digital signal; and
a processor (120) coupled to said input interface (121) and said analog-to-digital converter (124) for receiving the input signal and the digital signal therefrom, for outputting the control signal to said direct digital frequency synthesizer (13) based on the input signal from said input interface (121), and for outputting the adjusting signal to said oscillator module (11) based on the digital signal from said analog-to-digital converter (124).

3. The digitally controlled frequency generator (1) as claimed in Claim 1, **characterized in that** said oscillator module (11) includes one of a crystal resonator and an oven-controlled crystal oscillator.

## Patentansprüche

1. Digital gesteuerter Frequenzgenerator (1), der umfasst:
ein Oszillatormodul (11) zum Erzeugen eines ersten Taktsignals mit einer Schwingungsfrequenz;
ein programmierbares Steuermodul (12), das dafür betreibbar ist, ein Steuersignal zu erzeugen, das einer gewünschten Frequenz (fₒᵤₜ) entspricht, die mehr als das Doppelte einer vorgegebenen Schwingungsfrequenz (f_{osc}) ist;
einen Frequenzsensor (16), der mit dem Oszillatormodul (11) und mit dem programmierbaren Steuermodul (12) gekoppelt ist, wobei der Frequenzsensor (16) das von dem Oszillatormodul (11) erzeugte erste Taktsignal abtastet, um an das programmierbare Steuermodul (12) ein Erfassungssignal auszugeben;
wobei das programmierbare Steuermodul (12) auf der Grundlage des Erfassungssignals von dem Frequenzsensor (16) eine Differenz zwischen der Schwingungsfrequenz des ersten Taktsignals und der vorgegebenen Schwingungsfrequenz (f_{osc}) bestimmt, wobei das programmierbare Steuermodul (12) an das Oszillatormodul (11) ein Einstellsignal in Bezug auf das Erfassungssignal von dem Frequenzsensor (16) derart ausgibt, dass das Oszillatormodul (11) die **dadurch** erzeugte Schwingungsfrequenz des ersten Taktsignals in Reaktion auf das Einstellsignal von dem programmierbaren Steuermodul (12) auf die vorgegebene Schwingungsfrequenz (f_{osc}) einstellt, **dadurch gekennzeichnet, dass**
ein direkter digitaler Frequenzsynthetisierer (13), der mit dem Oszillatormodul (11) und mit dem programmierbaren Steuermodul (12) gekoppelt ist, davon das erste Taktsignal und das Steuersignal empfängt, und auf der Grundlage des ersten Taktsignals von dem Oszillatormodul (11) und des Steuersignals von dem programmierbaren Steuermodul (12) ein zweites Taktsignal mit der gewünschten Frequenz (fₒᵤₜ) erzeugt.

2. Digital gesteuerter Frequenzgenerator (1) nach Anspruch 1, ferner **dadurch gekennzeichnet, dass** das programmierbare Steuermodul (12) folgendes enthält:
eine Eingangsschnittstelle (121), die zum Empfangen eines der gewünschten Frequenz (fₒᵤₜ) entsprechenden Eingangssignals betreibbar ist;
einen Analog-Digital-Wandler (124), der mit dem Frequenzsensor (16) gekoppelt ist, um davon das Erfassungssignal zu empfangen und um das Erfassungssignal in ein digitales Signal umzusetzen; und
einen Prozessor (120), der mit der Eingangsschnittstelle (121) und mit dem Analog-Digital-Wandler (124) gekoppelt ist, um davon das Eingangssignal und das digitale Signal zu empfangen, um das Steuersignal auf der Grundlage des Eingangssignals von der Eingangsschnittstelle (121) an den direkten digitalen Frequenzsynthetisierer (13) auszugeben und um das Einstellsignal auf der Grundlage des digitalen Signals von dem Analog-Digital-Wandler (124) an das Oszillatormodul (11) auszugeben.

3. Digital gesteuerter Frequenzgenerator (1) nach Anspruch 1, **dadurch gekennzeichnet, dass** das Oszillatormodul (11) einen Quarzresonator und einen ofengesteuerten Quarzoszillator enthält.

## Revendications

1. Générateur de fréquence à commande numérique (1), comprenant :
un module d'oscillateur (11) pour générer un premier signal d'horloge ayant une fréquence d'oscillation ;
un module de commande programmable (12) pouvant fonctionner de façon à générer un signal de commande correspondant à une fréquence souhaitée (fₒᵤₜ) qui est plus du double d'une fréquence d'oscillation prédéterminée (f_{osc}) ;
un capteur de fréquence (16) couplé audit module d'oscillateur (11) et audit module de commande programmable (12), ledit capteur de fréquence (16) détectant le premier signal d'horloge généré par ledit module d'oscillateur (11) pour délivrer en sortie un signal de détection audit module de commande programmable (12) ;
où ledit module de commande programmable (12) détermine une différence entre la fréquence d'oscillation du premier signal d'horloge et la fréquence d'oscillation prédéterminée (f_{osc}) d'après le signal de détection dudit capteur de fréquence (16), ledit module de commande programmable (12) délivrant en sortie un signal d'ajustement audit module d'oscillateur (11) en référence au signal de détection dudit capteur de fréquence (16) de sorte que ledit module d'oscillateur (11) ajuste la fréquence d'oscillateur du premier signal d'horloge ainsi généré à la fréquence d'oscillation prédéterminée (f_{osc}) en réponse au signal d'ajustement dudit module de commande programmable (12),
**caractérisé en ce que**
un synthétiseur de fréquence numérique direct (13) couplé audit module d'oscillateur (11) et audit module de commande programmable (12) en reçoit le premier signal d'horloge et le signal de commande, et génère un deuxième signal d'horloge ayant la fréquence souhaitée (fₒᵤₜ) d'après le premier signal d'horloge dudit module d'oscillateur (11) et le signal de commande dudit module de commande programmable (12).

2. Générateur de fréquence à commande numérique (1) selon la revendication 1, **caractérisé en outre en ce que** ledit module de commande programmable (12) inclut :
une interface d'entrée (121) pouvant fonctionner de façon à recevoir un signal d'entrée correspondant à la fréquence souhaitée (fₒᵤₜ) ;
un convertisseur analogique-numérique (124) couplé audit capteur de fréquence (16) pour en recevoir le signal de détection et pour convertir le signal de détection en un signal numérique ; et
un processeur (120) couplé à ladite interface d'entrée (121) et audit processeur analogique-numérique (124) pour en recevoir le signal d'entrée et le signal numérique, pour délivrer en sortie le signal de commande audit synthétiseur de fréquence numérique direct (13) d'après le signal d'entrée de ladite interface d'entrée (121), et pour délivrer en sortie le signal d'ajustement audit module d'oscillateur (11) d'après le signal numérique provenant dudit convertisseur analogique-numérique (124).

3. Générateur de fréquence à commande numérique (1) selon la revendication 1, **caractérisé en ce que** ledit module d'oscillateur (11) inclut un résonateur à quartz et un oscillateur à quartz thermostaté.
